# EUROPEAN PATENT APPLICATION

(11) **EP 3 758 061 A1**
(43) Date of publication of application: **30.12.2020**
(21) Application number: 19189694.3
(22) Date of filing: 01.08.2019
(51) Int. Cl.: H01L 23/498, H01L 23/31, H01L 21/56

(54) **PACKAGING METHOD FOR ATTACHED SINGLE SMALL-SIZE AND ARRAY TYPE CHIP SEMICONDUCTOR COMPONENTS WITH ONE OR TWO CIRCUIT BOARDS WITH ELECTROPLATED THROUGH-INTERCONNECTIONS**

(30) Priority: 27.06.2019 TW 108122494
(71) Applicant: SFI Electronics Technology Inc., Taoyuan City 333 (TW)
(72) Inventor: Len, Ching-Hohn, 333 Taoyuan City (TW); Hhuang, Hsing-Hsiang, 333 Taoyuan City (TW); Huang, Hsing-Tsai, 333 Taoyuan City (TW); Chiu, Cheng-Hsien, 333 Taoyuan City (TW)
(74) Representative: Lang, Christian

(57) **Abstract**

A packaging method for attached (SMD-type) single small-size and array type chip semiconductor components is disclosed. The configuration of circuit board(s) (200, 300, 400, 450, 500, 600) with double-sided interconnections includes reserving two or more connection endpoints on the inner and outer layers of a double-sided circuit board (200, 300, 400, 450, 500, 550, 600, 650) and interconnecting the circuits (201, 301, 401, 501, 601) on the inner and outer layers by hole drilling and electroplating, such that the two or more connection endpoints on the inner layer are used as inner electrodes for connecting with a semiconductor die (210, 310, 410, 510, 610), whereas the two or more connection endpoints on the outer layer are used as outer electrodes for SMT soldering. A single circuit board (200) may be used, wherein an insulating encapsulant (230) is laid across the entire surface of the circuit board (200) with the attached semiconductor dies (210). Alternatively, a circuit board (300) is attached to the lower surface of the semiconductor dies (310) and a top cover plate (350) is bonded to the upper surface of the semiconductor dies (310) (a heat dissipating plate can also be attached to increase heat dissipation) or two circuit boards (400, 450, 500, 550, 600, 650) are attached to the semiconductor dies (410, 510, 610), and then an insulating encapsulant (330, 430, 530, 630) is filled in the space between the circuit board (300) and the top cover plate (350) or between the two circuit boards (400, 450, 500, 550, 600, 650). The insulating encapsulant is then cured, followed by dicing to form an attached single small-size or array type semiconductor component (or packaged product). When using two circuit boards (400, 450, 500, 550, 600, 650), either both circuit boards (400, 450) contain interconnections through electroplated holes or only one circuit board (500, 600) contains interconnections through electroplated holes and side electrode(s) are formed on the side of the package after dicing.

## Description

### FIELD OF THE INVENTION

The present invention relates to a novel method for manufacturing chip semiconductor packages, and more particularly, to a novel method for manufacturing attached single small-size and array type chip semiconductor packages.

### BACKGROUND OF THE INVENTION

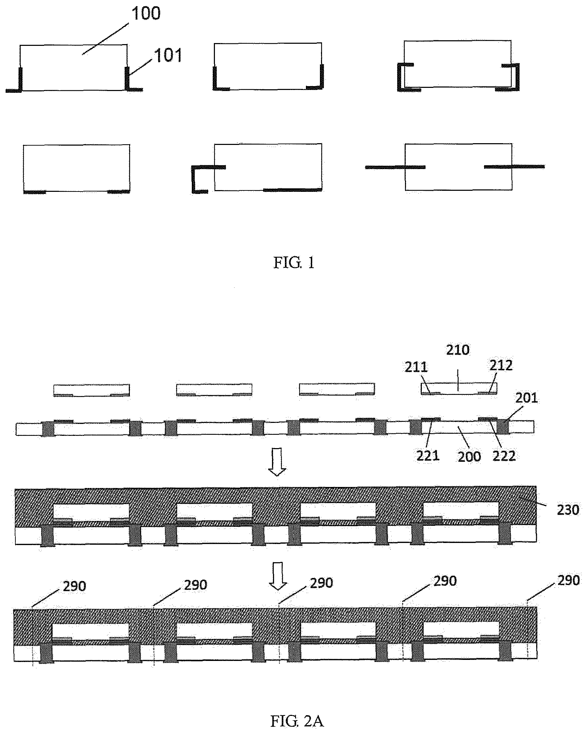

In a conventional semiconductor packaging process, after a lead frame is packaged by epoxy resin 100, outer pins 101 are typically left uncovered at both ends of a chip to facilitate subsequent soldering processes. There are various arrangements for the outer pins, some of which are shown in FIG. 1.

### SUMMARY OF THE INVENTION

The present invention provides a packaging method for an attached single small-size and array type chip semiconductor component, comprising: providing a die including a positive electrode and a negative electrode, and providing a circuit board with thin- or thick-film circuits on both sides thereof, reserving two or more connection endpoints in advance on both sides of the circuit board, and then vertically connecting the circuits on the top and bottom sides by hole drilling and electroplating; performing a baking process to bond the positive and negative electrodes of the die with the thin- or thick-film circuits using a conductive adhesive, covering the entire surface with an insulating encapsulant by a process such as lamination, coating, scraping, etc., and performing curing on the insulating encapsulant; performing dicing at locations other than the die to form a package structure without any outer pins to complete the manufacturing of a single small-size chip semiconductor; and forming a forward, reverse or bidirectional chip semiconductor component depending on the configuration of the die.

In the packaging method for an attached single small-size and array type chip semiconductor component of the present invention, the die includes one upper electrode and one bottom electrode, one upper electrode and two bottom electrodes, two upper electrodes and one bottom electrode, two bottom electrodes, one upper electrode and a plurality of bottom electrodes, a plurality of upper electrodes and one bottom electrode, etc.

The present invention provides a packaging method for an attached single small-size and array type chip semiconductor component, comprising: providing a die including a positive electrode and a negative electrode, and providing a circuit board with thin- or thick-film circuits on both sides thereof, reserving two or more connection endpoints in advance on both sides of the circuit board, vertically connecting the circuits on the top and bottom sides by hole drilling and electroplating; performing a baking process to connect the positive and negative electrodes of the die with the thin- or thick-film circuits using a conductive adhesive; and coating a surface of an upper cover plate with an adhesive for bonding the upper cover plate with the die, filling the inner space with an insulating encapsulant, and performing curing on the insulating encapsulant.

In the packaging method for an attached single small-size and array type chip semiconductor component of the present invention, the upper cover plate can be a ceramic plate (e.g. an alumina plate, an aluminum nitride plate, etc.), a plastic plate (e.g. made of PE, PP, PC, polyamidamine, engineering plastics, etc.), a composite board (e.g. a carbon fiber board, a fiberglass board, etc.), etc., and a heat dissipating plate can also be attached to increase heat dissipation.

In the packaging method for an attached single small-size and array type chip semiconductor component of the present invention, the circuit board with the thin- or thick-film circuits on both sides thereof further includes array type outer electrodes with double-side interconnections.

The present invention provides a packaging method for an attached single small-size and array type chip semiconductor component, comprising: providing a die including three electrodes, and providing at least two circuit boards with thin- or thick-film circuits on both sides of each of the circuit boards; performing a baking process to bond the three electrodes of the die with the thin- or thick-film circuits using a conductive adhesive; and filling the inner space with an insulating encapsulant, and performing curing on the insulating encapsulant.

In the packaging method for an attached single small-size and array type chip semiconductor component of the present invention, the packaged attached single small-size and array type chip semiconductor component has a configuration in which current flowing into one input and out of two outputs or a configuration of "forward plus ground lead", "reverse plus ground lead" and "bidirectional plus ground lead".

The present invention provides a packaging method for an attached single small-size and array type chip semiconductor component, comprising: providing a die including a positive electrode and a negative electrode, and providing at least two circuit boards with thin- or thick-film circuits on both sides of each of the circuit boards; performing a baking process to bond the positive and negative electrodes of the die with the thin- or thick-film circuits using a conductive adhesive; filling the inner space with an insulating encapsulant, and performing curing on the insulating encapsulant; forming an end electrode on one end after dicing by a process such as coating, silver coating, a thin-film manufacturing process, etc., such that the end electrode on the one end is interconnected with an electrode contact already in place to complete the manufacturing of a single small-size chip semiconductor; and performing an electroplating process to form a single SMD-type semiconductor chip component.

The present invention provides a packaging method for an attached single small-size and array type chip semiconductor component, comprising: providing a die including three electrodes, and providing at least two circuit boards with thin- or thick-film circuits on both sides of each of the circuit boards; performing a baking process to connect the three electrodes of the die with the thin- or thick-film circuits using a conductive adhesive; filling the inner space with an insulating encapsulant, and performing curing on the insulating encapsulant; forming end electrodes on two ends after dicing by a process such as coating, silver coating, a thin-film manufacturing process, etc., such that the end electrodes on the two ends are interconnected with electrode contacts already in place to complete the manufacturing of a single small-size three-electrode chip semiconductor; and performing an electroplating process to form a single SMD-type semiconductor chip component.

In the packaging method for an attached single small-size and array type chip semiconductor component of the present invention, the circuit board with the thin- or thick-film circuits on both sides thereof further includes array type outer electrodes of a double-sided interconnection configuration, and a single side of the circuit board further includes horizontally lead out electrodes at two ends, forming end electrodes on the two ends after dicing by a process such as coating, silver coating, a thin-film manufacturing process, etc., such that the two end electrodes are interconnected with the electrode contacts already in place.

In the packaging method for an attached single small-size and array type chip semiconductor component of the present invention, the specification of the chip includes:

| Type | # of End electrode | Length | Width | Thickness | Note |
|---|---|---|---|---|---|
| Single 01005 | 2 | 0.4 mm | 0.2 mm | 0.2 mm | Thickness can be fine-tuned |
| Single 0201 | ≤ 3 | 0.6 mm | 0.3 mm | 0.3 mm | Thickness can be fine-tuned |
| Single 0402 | ≤ 3 | 1.0 mm | 0.5 mm | 0.5 mm | Thickness can be fine-tuned |
| Array 0204 | ≥4 | 1.0 mm | 0.5 mm | 0.3 mm | Thickness can be fine-tuned |
| Array 0306 | ≥4 | 1.6 mm | 0.8 mm | 0.4 mm | Thickness can be fine-tuned |
| Array 0405 | ≥4 | 1.3 mm | 1.0 mm | 0.4 mm | Thickness can be fine-tuned |
| Array 0508 | ≥4 | 2.0 mm | 1.3 mm | 0.5 mm | Thickness can be fine-tuned |
| Array 0510 | ≥4 | 2.5 mm | 1.3 mm | 0.5 mm | Thickness can be fine-tuned |
| Array 0612 | ≥4 | 3.0 mm | 1.5 mm | 0.6 mm | Thickness can be fine-tuned |

In the packaging method for an attached single small-size and array type chip semiconductor component of the present invention, the type of the chip includes a TVS diode, a Schottky diode, a switching diode, a Zener diode, a rectifier diode and a transistor, etc., but it is not limited to these six types of semiconductor dies, any types of chips in any semiconductor die placement processes are applicable.

In the packaging method for an attached single small-size and array type chip semiconductor component of the present invention, the thin- or thick-film circuits of the circuit board are manufactured on a ceramic plate (e.g. an alumina plate, an aluminum nitride plate, etc.), a plastic plate (e.g. made of PE, PP, PC, polyamidamine, engineering plastics, etc.), a composite board (e.g. a carbon fiber board, a fiberglass board, etc.), etc., or printed on a heat dissipating plate to increase heat dissipation.

In the packaging method for an attached single small-size and array type chip semiconductor component of the present invention, the conductive adhesive is any conductive adhesive (e.g. silver paste, silver palladium paste, palladium paste, platinum paste, copper paste, nickel paste, aluminum paste, tin paste, tin lead paste, etc.) for bonding the semiconductor die with printed circuits, and lead-free conductive adhesive (e.g. silver paste, silver palladium paste, palladium paste, platinum paste, copper paste, nickel paste, aluminum paste, tin paste, etc.) can be used to replace traditional lead solder paste to produce lead-free semiconductor packaging products.

In the packaging method for an attached single small-size and array type chip semiconductor component of the present invention, the insulating encapsulant encapsulates the die, the conductive adhesive and the internal circuit boards by a process such as lamination, coating, scraping, filling, etc. to protect the electrical and physical characteristics of the die.

In the packaging method for an attached single small-size and array type chip semiconductor component of the present invention, the die can be manufactured into a forward, reverse, or bidirectional chip semiconductor component depending on the configuration of the semiconductor, the configuration may be "one-input-one-output" or "one-input-two-output".

In the packaging method for an attached single small-size and array type chip semiconductor component of the present invention, the end electrodes undergo electroplating or formed from a material (e.g. Ag, Au, Pd, Pt, Ag/Pd alloy, Ag/Pt alloy, etc.) that has solderability without electroplating to produce the attached single small-size and array type chip semiconductor component.

In the packaging method for an attached single small-size and array type chip semiconductor component of the present invention, the thin-film circuits are formed using a thin-film manufacturing process (e.g. sputtering, evaporation, electroless plating, yellowing, developing, etching, etc.), and the thick-film circuits are formed by printing.

### BRIEF DESCRIPTION OF THE DRAWINGS

FIG. 1 is a schematic diagram illustrating a prior-art packaging and manufacturing method for a single small-size chip semiconductor with the configuration of a circuit board with double-side interconnections only.
FIGs. 2A to 2C are schematic diagrams illustrating a first embodiment of a packaging method for an attached single small-size and array type chip semiconductor component of the present invention.
FIGs. 3A to 3C are schematic diagrams illustrating a second embodiment of a packaging method for an attached single small-size and array type chip semiconductor component of the present invention.
FIGs. 4A to 4C are schematic diagrams illustrating a third embodiment of a packaging method for an attached single small-size and array type chip semiconductor component of the present invention.
FIGs. 5A to 5D are schematic diagrams illustrating a fourth embodiment of a packaging method for an attached single small-size and array type chip semiconductor component of the present invention.
FIGs. 6A to 6D are schematic diagrams illustrating a fifth embodiment of a packaging method for an attached single small-size and array type chip semiconductor component of the present invention.
FIG. 7A is a schematic diagram illustrating a sixth embodiment of a packaging method for an attached single small-size and array type chip semiconductor component of the present invention.
FIG. 8A is a schematic diagram illustrating a seventh embodiment of a packaging method for an attached single small-size and array type chip semiconductor component of the present invention.

### DETAILED DESCRIPTION OF THE EMBODIMENTS

In order to fully understand the objectives, features and technical effects of the present invention, the present invention is explained in details by way of various embodiments below in conjunction with the attached drawings.

The present invention includes the use of circuit board(s) with double-side interconnections alone or the simultaneous use of a circuit board with single-side interconnections and another circuit board with double-side interconnections for connecting between a semiconductor chip and electrodes. The circuits can be formed by a thin-film manufacturing process, a thick-film printing process, or the like on a ceramic plate (e.g. an alumina plate, an aluminum nitride plate, etc.), a plastic plate (e.g. made of PE, PP, PC, polyamidamine, engineering plastics, etc.), a composite board (e.g. a carbon fiber board, a fiberglass board, etc.), etc. The configuration of a circuit board with single-side interconnections includes reserving two or more connection endpoints on a single side of the circuit board and leading the circuits out horizontally to the sides. On the other hand, the configuration of a circuit board with double-side interconnections includes reserving two or more connection endpoints on both sides of the circuit board, vertically connecting the top and bottom circuit through the hole drilling and electroplating processes, and the circuits on the inner layer are used as inner electrodes for connecting with a semiconductor die, while the circuits on the outer layer are used as outer electrodes for connecting with a SMT board.

Lead-free conductive paste (e.g. silver paste, silver palladium paste, palladium paste, platinum paste, copper paste, nickel paste, aluminum paste, tin paste, tin lead paste, etc.) is dispensed on two or more connection endpoints, and a semiconductor die is placed on the conductive adhesive. Positioning in the dispensing and die placement processes can both be carried out using a CCD to accurately placing the semiconductor die on reserved electrodes for connecting the semiconductor die with thin- or thick-film circuits. Two or more electrodes of the semiconductor die can be interconnected with the reserved inner electrodes to satisfy packaging for single small-size semiconductor dies (e.g. 01005, 0201, 0402 etc.) or array type semiconductor dies (e.g. 0204, 0306, 0405, 0508, 0510, 0612).

An insulating encapsulant is laid across the entire surface by a method such as lamination, coating, scraping, filling, etc., wherein lamination and coating can be repeated a plurality of times to build up the insulating encapsulant to a certain thickness, and scraping and filling can also be repeated one or two times to achieve a certain thickness of the insulating encapsulant. After the insulating encapsulant is cured, dicing can be carried out. If the configuration of the circuit board with double-side interconnections is used, an attached single small-size or array type semiconductor component (or packaged product) is formed after dicing. On the other hand, if the configuration of both circuit boards with single-side and double-side interconnections is used, inner electrodes lead out to the sides have to be interconnected with outer electrodes after dicing through a process such as coating, silver coating, a thin-film manufacturing process, etc. An attached single small-size or array type semiconductor component (or packaged product) can then be formed after electroplating.

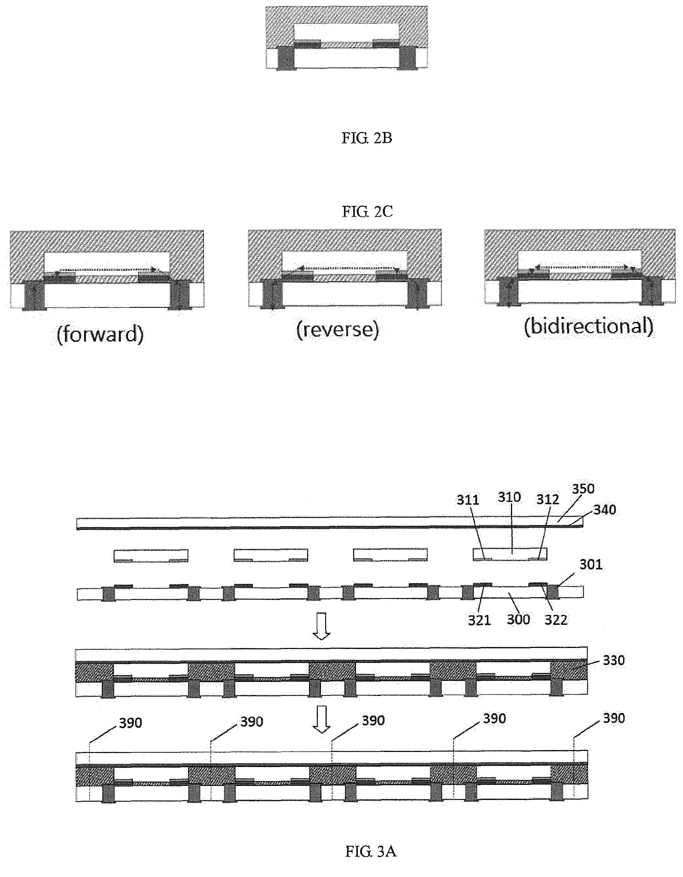

Embodiment 1: A packaging and manufacturing method for a single small-size chip semiconductor including the use of a circuit board with double-side interconnections only is shown: (1) As shown in FIG. 2A, thin- or thick-film circuits 201 are provided on both sides of a circuit board 200 with two or more connection endpoints reserved in advance on both sides of the circuit board. The circuits on the top and bottom sides are then connected vertically through hole drilling and electroplating. Positive and negative electrodes 211 and 212 included on a semiconductor chip 210 are connected with the thin- or thick-film circuit 201 using conductive adhesive 221 and 222 through a baking process. An insulating encapsulant 230 is then laid over the entire surface by a process such as lamination, coating, scraping, etc., and curing is performed on the insulating encapsulant 230. (2) Thin-film circuits can be formed using a thin-film manufacturing process (e.g. sputtering, evaporation, electroless plating, yellowing, developing, etching, etc.). Thick-film circuits can be formed by printing. (3) Dicing is performed at locations 290 to create package structures with no outer pins, thereby completing the manufacturing of single small-size (e.g. 01005, 0201, 0402, etc.) chip semiconductor and providing single SMD-type semiconductor components, as shown in FIG. 2B. (4) Depending on the configuration of the chip, a forward, reverse or bidirectional chip semiconductor component can be formed, as shown in FIG. 2C.

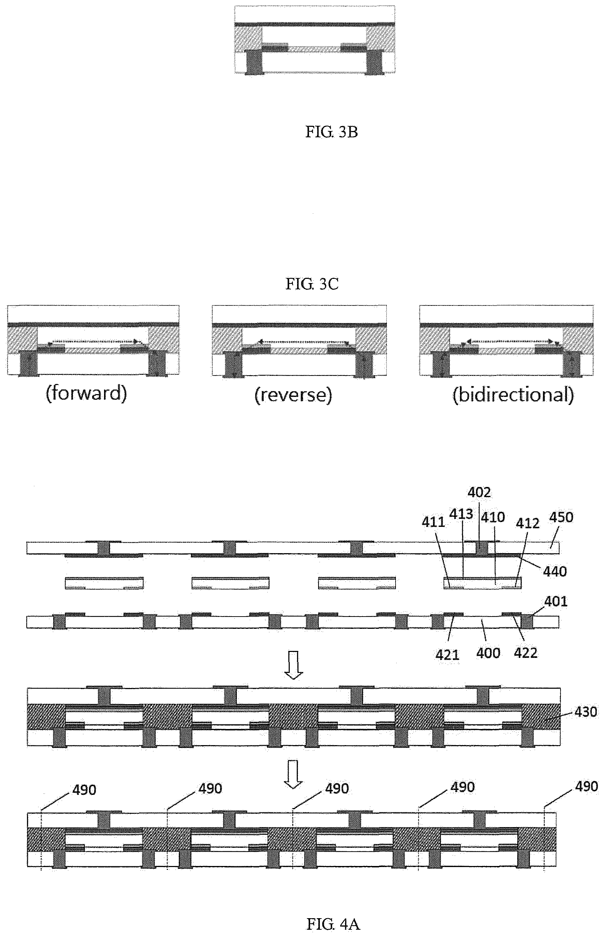

Embodiment 2: A packaging and manufacturing method for a single small-size chip semiconductor including a cover plate and the use of a circuit board with double-side interconnections only is shown: (1) As shown in FIG. 3A, thin- or thick-film circuits 301 are provided on both sides of a circuit board 300 with two or more connection endpoints reserved in advance on both sides of the circuit board. The circuits on the top and bottom sides are then connected vertically through hole drilling and electroplating. Positive and negative electrodes 311 and 312 included on a semiconductor chip 310 are connected with the thin- or thick-film circuit 301 using conductive adhesive 321 and 322 through a baking process. (2) The surface of a top cover 350 is coated with an adhesive 340 to bond the top cover 350 onto the chips 310. The top cover can be a ceramic plate (e.g. an alumina plate, an aluminum nitride plate, etc.), a plastic plate (e.g. made of PE, PP, PC, polyamidamine, engineering plastics, etc.), a composite board (e.g. a carbon fiber board, a fiberglass board, etc.), etc.. A heat dissipating plate can also be attached to increase heat dissipation. (3) The inner space is filled with an insulating encapsulant 330 and curing is performed on the insulating encapsulant 330. (4) Dicing is performed at locations 390 to create package structures with no outer pins, as shown in FIG. 3B. (5) Depending on the configuration of the chip, a forward, reverse or bidirectional chip semiconductor component can be formed, as shown in FIG. 3C.

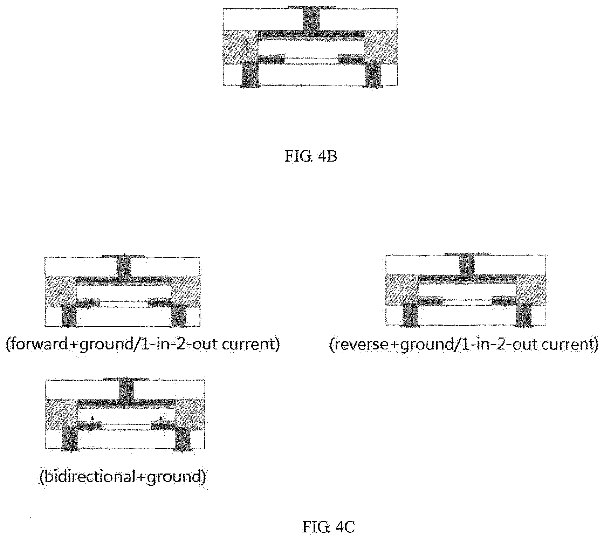

Embodiment 3: A packaging and manufacturing method for a single small-size chip semiconductor including three electrodes and the use of circuit boards with double-side interconnections only is shown: (1) As shown in FIG. 4A, thin- or thick-film circuits 401 are provided on both sides of a circuit board 400 with two or more connection endpoints reserved in advance on both sides of the circuit board 400, and the circuits on the top and bottom sides thereof are then connected vertically through hole drilling and electroplating. Thin- or thick-film circuits 402 are provided on both sides of another circuit board 450 with one or more connection endpoints reserved in advance on both sides of the circuit board, and the circuits on the top and bottom sides thereof are then connected vertically through hole drilling and electroplating. Positive and negative electrodes 411 and 412 and a ground lead 413 are included on a semiconductor chip 410. These three electrodes 411, 412 and 413 of the semiconductor chip are then connected with the thin- or thick-film circuits 401 and 402 using conductive adhesive 421, 422 and 440 through a baking process. (2) The inner space is then filled with an insulating encapsulant 430 and curing is performed on the insulating encapsulant 430. (3) Dicing is performed at locations 490 to create package structures with no outer pins, as shown in FIG. 4B. (4) Depending on the configuration of the chip, a "forward + ground lead", "reverse + ground lead", and "bidirectional + ground lead", or "one-in and two-out current direction"-type chip semiconductor component can be formed, as shown in FIG. 4C.

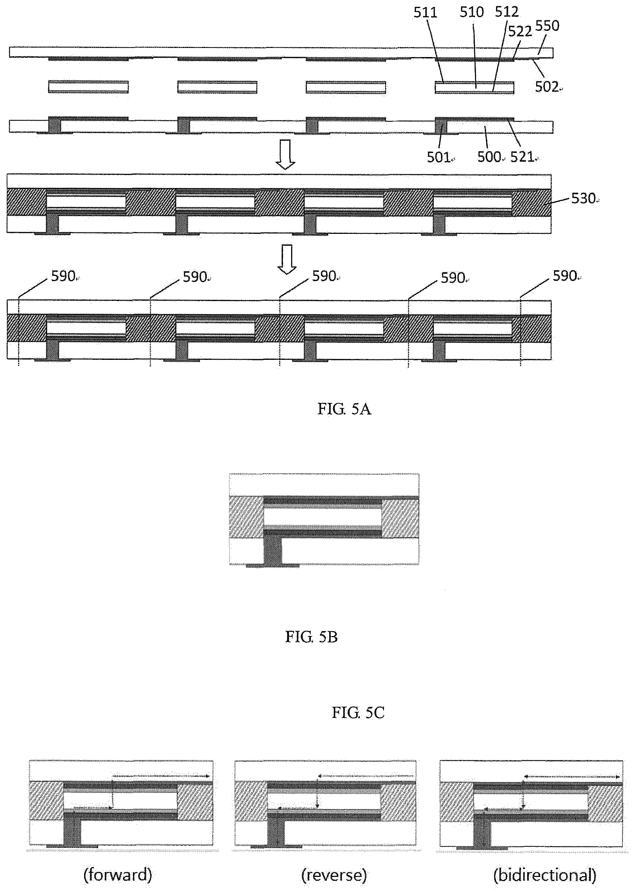

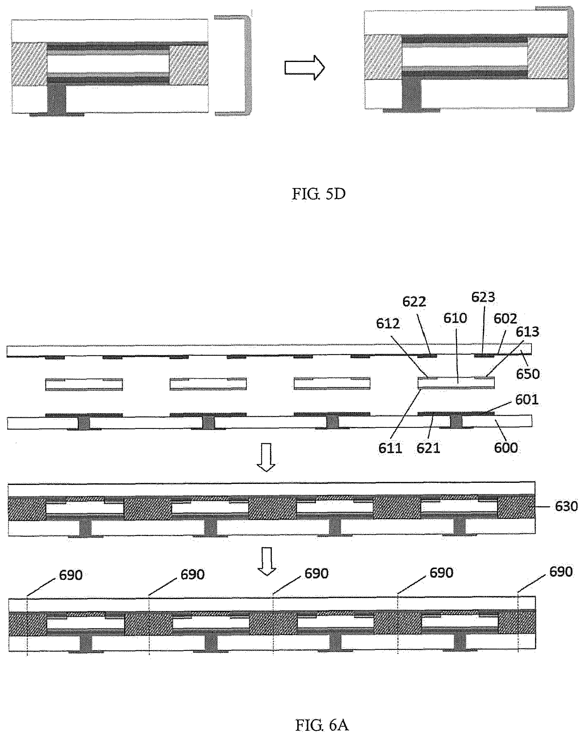

Embodiment 4: A packaging and manufacturing method for a single small-size chip semiconductor including the use of both a circuit board with single-side interconnection and a circuit board with double-side interconnections is shown: (1) As shown in FIG. 5A, thin- or thick-film circuits 501 are provided on both sides of a circuit board 500 with two or more connection endpoints reserved in advance on both sides of the circuit board 500, and the circuits on the top and bottom sides thereof are then connected vertically through hole drilling and electroplating. A thin- or thick-film circuit 502 is provided on a single side of a circuit board 550. Positive and negative electrodes 511 and 512 included on a semiconductor chip 510 are connected with the thin- or thick-film circuits 501 and 502 using conductive adhesive 521 and 522 through a baking process. (2) The inner space is filled with an insulating encapsulant 530 and curing is performed on the insulating encapsulant 530. (3) Dicing is performed at locations 590 to create package structures with no outer pins on one side and one outer pin on the other side thereof, as shown in FIG. 5B. (4) Depending on the configuration of the chip, a forward, reverse or bidirectional chip semiconductor component can be formed, as shown in FIG. 5C. (5) The inner electrode lead out to an end of the circuit board with the single-side interconnections is interconnected with an outer electrode through a process such as coating, silver coating, a thin-film manufacturing process, etc.. After electroplating, a single small-size (e.g. 01005, 0201, 0402, etc.) chip semiconductor SMD-type semiconductor chip can then be formed, as shown in FIG. 5D.

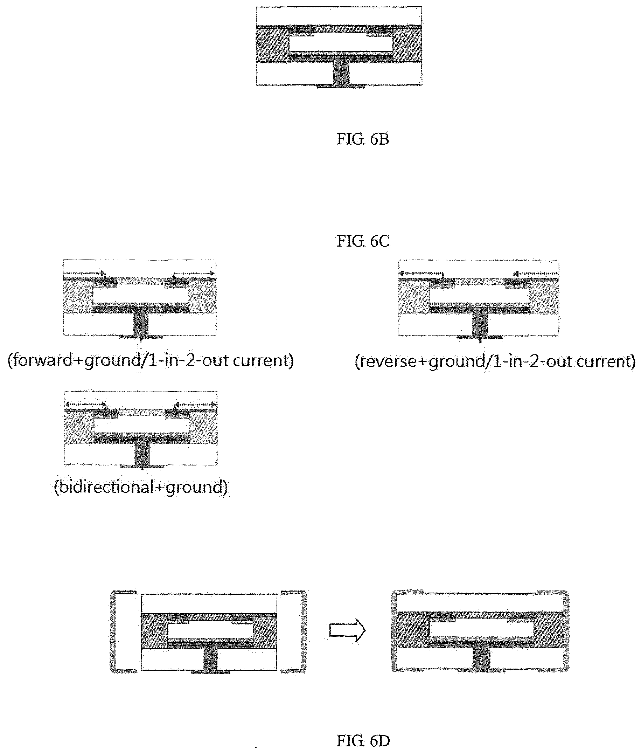

Embodiment 5: A packaging and manufacturing method for a single small-size chip semiconductor including three electrodes and both a circuit board with single-side interconnection and a circuit board with double-side interconnections is shown: (1) As shown in FIG. 6A, thin- or thick-film circuits 601 are provided on both sides of a circuit board 600 with two or more connection endpoints reserved in advance on both sides of the circuit board 600, and the circuits on the top and bottom sides thereof are then connected vertically through hole drilling and electroplating. A thin- or thick-film circuit 602 is provided on a single side of a circuit board 650. Positive and negative electrodes 611, 612 and 613 are included on a semiconductor chip 610. The three electrodes 611, 612 and 613 of the semiconductor chip 610 are then connected with the thin- or thick-film circuits 601 and 602 using conductive adhesive 621, 622 and 623 through a baking process. (2) The inner space is filled with an insulating encapsulant 630 and curing is performed on the insulating encapsulant 630. (3) Dicing is performed at locations 690 to create package structures with no outer pins on one side and two outer pins on the other side thereof, as shown in FIG. 6B. (4) Depending on the configuration of the chip, a three-electrode chip semiconductor component can be formed, as shown in FIG. 6C. The configuration may include "forward + ground lead", "reverse + ground lead", and "bidirectional + ground lead", or "one-in and two-out current direction"-type chip semiconductor components. (5) Two end electrodes are formed through a process such as coating, silver coating, a thin-film manufacturing process, etc., and these two end electrodes are connected with the electrode contacts already in place, thereby completing the packaging of a single small-size (e.g. 01005, 0201, 0402, etc.) chip semiconductor. After electroplating, a single SMD-type semiconductor chip is formed, as shown in FIG. 6D.

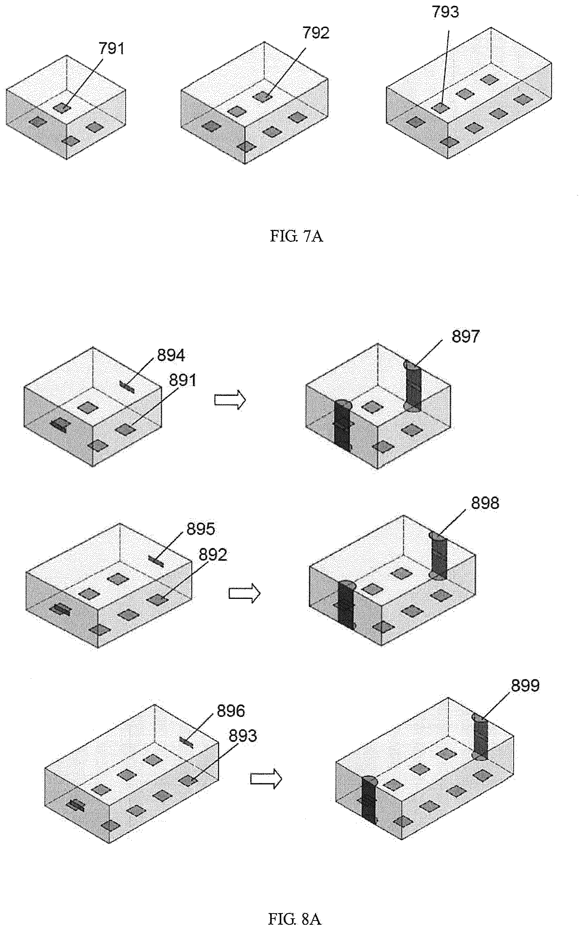

Embodiment 6: A packaging and manufacturing method for an array type chip semiconductor including the use of a circuit board with double-side interconnections only is shown: (1) A plurality of connection endpoints are arranged in an array on the inner and outer layers of a double-sided circuit board. The circuits on the top and bottom sides are connected vertically through hole drilling and electroplating to form 2×2 (791), 2×3 (792), 2×4 (793) array type outer electrodes. (2) Packaging is performed using the method described in Embodiment 1 or 2, thereby completing the manufacturing of an array type (e.g. 0204, 0306, 0405, 0508, etc.) chip semiconductor, as shown in FIG. 7A.

Embodiment 7: A packaging and manufacturing method for an array type chip semiconductor including the use of both a circuit board with single-side interconnection and a circuit board with double-side interconnections is shown: (1) The configuration of the circuit board with the double-side interconnection includes allowing a plurality of connection endpoints to be arranged in an array on the inner and outer layers of a double-sided circuit board. The circuits on the top and bottom sides are connected vertically through hole drilling and electroplating to form 2×2 (891), 2×3 (892), 2×4 (893) array type outer electrodes. The configuration of the circuit board with single-side interconnection includes leading the circuit on the inner layer of a single-sided circuit board horizontally out to the end(s), for example, shown by reference numerals 894, 895 and 896. (2) Packaging is performed using the method described in Embodiment 5. After dicing, two end electrodes are formed through a process such as coating, silver coating, a thin-film manufacturing process, etc., and these two end electrodes are connected with the electrode contacts already in place, for example, shown by reference numerals 897, 898 and 899. After electroplating, an array type (e.g. 0204, 0306, 0405, 0508, etc.) chip semiconductor can be formed, as shown in FIG. 8A.

In conclusion, a plurality of packaging methods for attached single small-size and array type chip semiconductor components can be provided by the present invention.

The present invention has been disclosed in the preferred embodiment above. However, it can be appreciated by one of ordinary skill in the art that these embodiments are illustrative rather than limitations of the scope of the present invention. It should be noted that the above embodiments can be modified and replaced with equivalents thereof without departing from the scope of the present invention. Therefore, the scope claimed of the present invention should only be defined by the following claims.

## Claims

1. A packaging method for an attached single small-size and array type chip semiconductor component, comprising:
providing a die including a positive electrode and a negative electrode, and providing a circuit board with thin- or thick-film circuits on both sides thereof, reserving two or more connection endpoints in advance on both sides of the circuit board, and then vertically connecting the circuits on the top and bottom sides by hole drilling and electroplating;
performing a baking process to bond the positive and negative electrodes of the die with the thin- or thick-film circuits using a conductive adhesive, covering the entire surface with an insulating encapsulant by a process of one of lamination, coating and scraping, and performing curing on the insulating encapsulant;
performing dicing at locations other than the die to form a package structure without any outer pins to complete the manufacturing of a single small-size chip semiconductor; and
forming a forward, reverse or bidirectional chip semiconductor component depending on the configuration of the die.

2. The packaging method for an attached single small-size and array type chip semiconductor component of claim 1, wherein the die includes at least one of one upper electrode and one bottom electrode, one upper electrode and two bottom electrodes, two upper electrodes and one bottom electrode, two bottom electrodes, one upper electrode and a plurality of bottom electrodes, and a plurality of upper electrodes and one bottom electrode.

3. A packaging method for an attached single small-size and array type chip semiconductor component, comprising:
providing a die including a positive electrode and a negative electrode, and providing a circuit board with thin- or thick-film circuits on both sides thereof, reserving two or more connection endpoints in advance on both sides of the circuit board, vertically connecting the circuits on the top and bottom sides by hole drilling and electroplating;
performing a baking process to connect the positive and negative electrodes of the die with the thin- or thick-film circuits using a conductive adhesive; and
coating a surface of an upper cover plate with an adhesive for bonding the upper cover plate with the die, filling the inner space with an insulating encapsulant, and performing curing on the insulating encapsulant.

4. The packaging method for an attached single small-size and array type chip semiconductor component of claim 3, wherein the upper cover plate is a ceramic plate (at least one of an alumina plate and an aluminum nitride plate), a plastic plate (made of at least one of PE, PP, PC, polyamidamine and engineering plastics) or a composite board (at least one of a carbon fiber board and a fiberglass board), and a heat dissipating plate can also be attached to increase heat dissipation.

5. The packaging method for an attached single small-size and array type chip semiconductor component of claim 1 or 3, wherein the circuit board with the thin- or thick-film circuits on both sides thereof further includes array type outer electrodes with double-side interconnections.

6. A packaging method for an attached single small-size and array type chip semiconductor component, comprising:
providing a die including three electrodes, and providing at least two circuit boards with thin- or thick-film circuits on both sides of each of the circuit boards;
performing a baking process to bond the three electrodes of the die with the thin- or thick-film circuits using a conductive adhesive; and
filling the inner space with an insulating encapsulant, and performing curing on the insulating encapsulant.

7. The packaging method for an attached single small-size and array type chip semiconductor component of claim 6, wherein the packaged attached single small-size and array type chip semiconductor component has a configuration in which current flowing into one input and out of two outputs or a configuration of "forward plus ground lead", "reverse plus ground lead" and "bidirectional plus ground lead".

8. A packaging method for an attached single small-size and array type chip semiconductor component, comprising:
providing a die including a positive electrode and a negative electrode, and providing at least two circuit boards with thin- or thick-film circuits on both sides of each of the circuit boards;
performing a baking process to bond the positive and negative electrodes of the die with the thin- or thick-film circuits using a conductive adhesive;
filling the inner space with an insulating encapsulant, and performing curing on the insulating encapsulant;
forming an end electrode on one end after dicing by a process such as coating, silver coating, a thin-film manufacturing process, etc., such that the end electrode on the one end is interconnected with an electrode contact already in place to complete the manufacturing of a single small-size chip semiconductor; and
performing an electroplating process to form a single SMD-type semiconductor chip component.

9. A packaging method for an attached single small-size and array type chip semiconductor component, comprising:
providing a die including three electrodes, and providing at least two circuit boards with thin- or thick-film circuits on both sides of each of the circuit boards;
performing a baking process to connect the three electrodes of the die with the thin- or thick-film circuits using a conductive adhesive;
filling the inner space with an insulating encapsulant, and performing curing on the insulating encapsulant;
forming end electrodes on two ends after dicing by a process such as coating, silver coating, a thin-film manufacturing process, etc., such that the end electrodes on the two ends are interconnected with electrode contacts already in place to complete the manufacturing of a single small-size three-electrode chip semiconductor; and
performing an electroplating process to form a single SMD-type semiconductor chip component.

10. The packaging method for an attached single small-size and array type chip semiconductor component of claim 9, wherein the circuit board with the thin- or thick-film circuits on both sides thereof further includes array type outer electrodes of double-sided interconnection, and a single side of the circuit board further includes horizontally lead out electrodes at two ends, forming end electrodes on the two ends after dicing by a process such as coating, silver coating, a thin-film manufacturing process, etc., such that the two end electrodes are interconnected with the electrode contacts already in place.

11. The packaging method for an attached single small-size and array type chip semiconductor component of claim 1, 3, 6, 8 or 9, wherein the specification of the chip includes:
a. Single 01005 type, 2 of end electrode, 0.4mm length, 0.2mm width and 0.2mm thickness (thickness can be fine-tuned);
b. Single 0201 type, ≤ 3 of end electrode, 0.6mm length, 0.3mm width and 0.3mm thickness (thickness can be fine-tuned);
c. Single 0402 type, ≤ 3 of end electrode, 1.0mm length, 0.5mm width and 0.5mm thickness (thickness can be fine-tuned);
d. Array 0204 type, ≥4 of end electrode, 1.0mm length, 0.5mm width and 0.3 mm thickness (thickness can be fine-tuned);
e. Array 0306 type, ≥4 of end electrode, 1.6mm length, 0.8mm width and 0.4mm thickness (thickness can be fine-tuned);
f. Array 0405 type, ≥4 of end electrode, 1.3mm length, 1.0mm width and 0.4mm thickness (thickness can be fine-tuned);
g. Array 0508 type, ≥4 of end electrode, 2.0mm length, 1.3mm width and 0.5mm thickness (thickness can be fine-tuned);
h. Array 0510 type, ≥4 of end electrode, 2.5mm length, 1.3mm width and 0.5mm thickness (thickness can be fine-tuned);
i. Array 0612 type, ≥4 of end electrode, 3.0mm length, 1.5mm width and 0.6mm thickness (thickness can be fine-tuned);

12. The packaging method for an attached single small-size and array type chip semiconductor component of claim 1 or 3, wherein the type of the chip includes one of a TVS diode, a Schottky diode, a switching diode, a Zener diode, a rectifier diode and a transistor, but it is not limited to these six types of semiconductor dies, any types of chips in any semiconductor die placement processes are applicable.

13. The packaging method for an attached single small-size and array type chip semiconductor component of claim 1, 3, 6, 8 or 9, wherein the thin- or thick-film circuits of the circuit board are manufactured on a ceramic plate (at least one of an alumina plate and an aluminum nitride plate), a plastic plate (made of at least one of PE, PP, PC, polyamidamine and engineering plastics) or a composite board (at least one of a carbon fiber board and a fiberglass board), or printed on a heat dissipating plate to increase heat dissipation.

14. The packaging method for an attached single small-size and array type chip semiconductor component of claim 1, 3, 6, 8 or 9, wherein the conductive adhesive is any conductive adhesive (at least one of silver paste, silver palladium paste, palladium paste, platinum paste, copper paste, nickel paste, aluminum paste, tin paste and tin lead paste) for bonding the semiconductor die with printed circuits, and lead-free conductive adhesive (at least one of silver paste, silver palladium paste, palladium paste, platinum paste, copper paste, nickel paste, aluminum paste and tin paste) can be used to replace traditional lead solder paste to produce lead-free semiconductor packaging products.

15. The packaging method for an attached single small-size and array type chip semiconductor component of claim 1, 3, 6, 8 or 9, wherein the insulating encapsulant encapsulates the die, the conductive adhesive and the internal circuit boards by a process of at least one of lamination, coating, scraping and filling to protect the electrical and physical characteristics of the die.

16. The packaging method for an attached single small-size and array type chip semiconductor component of claim 1, 3, 6, 8, or 9, wherein the die can be manufactured into a forward, reverse, or bidirectional chip semiconductor component depending on the configuration of the semiconductor, the configuration may be "one-input-one-output" or "one-input-two-output".

17. The packaging method for an attached single small-size and array type chip semiconductor component of claim 8 or 9, wherein the end electrodes undergo electroplating or formed from a material (at least one of Ag, Au, Pd, Pt, Ag/Pd alloy and Ag/Pt alloy) that has solderability without electroplating to produce the attached single small-size and array type chip semiconductor component.

18. The packaging method for an attached single small-size and array type chip semiconductor component of claim 1, 3, 6, 8, or 9, wherein the thin-film circuits are formed using a thin-film manufacturing process (at least one of sputtering, evaporation, electroless plating, yellowing, developing and etching), and the thick-film circuits are formed by printing.
